# DEMANDE DE BREVET EUROPEEN

(11) **EP 1 367 650 A1**
(43) Date de publication de la demande: **03.12.2003**
(21) Numéro de dépôt: 03291210.7
(22) Date de dépôt: 22.05.2003
(51) Int. Cl.: H01L 31/0232, H01L 31/0216

(54) **Dispositif éelectronique comprenant des circuits électriques et une zone photosensible, et procédé de fabrication d'un tel dispositif**

(30) Priorité: 27.05.2002 FR 0206432
(71) Demandeur: STMicroelectronics S.A., 92120 Montrouge (FR)
(72) Inventeur: Roy, Francois, 38000 Grenoble (FR)
(74) Mandataire: Verdure, Stéphane

(57) **Abrégé**

Un dispositif électronique comprend une zone photosensible (3) et des circuits électriques (10) répartis au sein d'un matériau isolant (2). La zone photosensible et le matériau isolant sont disposés à la surface (S) d'un substrat (1). Le matériau isolant s'étend jusqu'à une première hauteur (h1) par rapport à la surface du substrat, et un matériau transparent (4) recouvre ladite zone photosensible jusqu'à une seconde hauteur (h2) par rapport à la surface du substrat. Ladite seconde hauteur (h2) est inférieure à ladite première hauteur (h1). Selon un procédé de fabrication avantageux du dispositif électronique, le matériau transparent (4) est identique au matériau isolant (2), et le procédé comprend une étape de retrait du matériau transparent entre ladite première hauteur (h1) et ladite seconde hauteur (h2).

## Description

La présente invention concerne un dispositif électrique comprenant un support semiconducteur sur lequel sont élaborés une cellule photosensible et des circuits électroniques. Elle se rapporte plus précisément aux moyens de couplage optique entre une face d'entrée de la lumière dans la cellule et un élément photosensible agencé au niveau de la surface du support semiconducteur.

De nombreux composants optiques intègrent une cellule photosensible. De tels composants sont, par exemple, des détecteurs optiques constitués d'un seul élément, ou cellule, sensible à la lumière incidente sur une face d'entrée de cette cellule. Il peut aussi s'agir de détecteurs optiques formés d'une matrice de cellules photosensibles juxtaposées les unes à côté des autres, dont les faces d'entrée respectives sont situées dans un même plan. Dans ce cas, les cellules peuvent être distinguées par leur emplacement au sein de la matrice, par exemple pour la détection de la position d'un point lumineux sur la surface de cette matrice.

Des cellules photosensibles appartenant à une matrice peuvent aussi être distinguées par la longueur d'onde de la lumière à laquelle chacune d'entre elles est sensible, ou encore distinguées par une combinaison de la longueur d'onde de sensibilité et de l'emplacement de la cellule au sein de la matrice, par exemple pour la détection d'images lumineuses polychromatiques.

Dans de tels composants, la cellule photosensible est de dimensions réduites pour obtenir une bonne résolution spatiale. Elle présente par exemple une face d'entrée de la lumière de dimensions approximatives égales à 5,6 µm x 5,6 µm (µm signifiant micromètre), qui limite la quantité de lumière entrant dans la cellule photosensible.

La cellule occupe en général un volume globalement cylindrique, dont la section dans un plan orthogonal à l'axe principal de ce cylindre est de forme variée. Lorsqu'on représente la cellule photosensible en coupe dans un plan contenant son axe principal, on représente en général cet axe suivant la verticale, avec la face d'entrée en haut et l'élément photosensible en bas. Dans la suite, les termes «inférieur» et «supérieur», «sur» et «sous» utilisés en relation avec la désignation des éléments constitutifs de la cellule photosensible ou de la matrice photosensible, le sont par référence à cette convention. La cellule photosensible est ainsi limitée dans sa partie supérieure par la face d'entrée, et dans sa partie inférieure par un support, ou substrat, semiconducteur dont la surface tournée vers l'intérieur de la cellule est sensiblement plane et parallèle à la face d'entrée.

L'élément photosensible est en général constitué d'une portion de surface du substrat semi-conducteur spécialement traitée pour remplir cette fonction, et qui est désignée ci-après par zone photosensible. Au niveau de cette zone, pour accroître la sensibilité de détection lumineuse, la surface interne du substrat peut avoir été rendue particulièrement rugueuse, mais elle conserve une géométrie globale sensiblement plane.

La surface du substrat comporte à l'intérieur de la cellule, outre la zone photosensible précédente, une portion de surface occupée par des composants électroniques intégrés à la cellule. Ces composants font partie des moyens de lecture et de contrôle de la cellule photosensible. La zone photosensible possède donc une superficie inférieure à la superficie de la face d'entrée. Par exemple, les dimensions de la zone photosensible sont 2 µm x 2 µm pour une face d'entrée de 5,6 µm x 5,6 µm. La zone photosensible est disposée de façon centrée par rapport à la face d'entrée, et donc centrée par rapport à l'axe de la cellule. Les composants électroniques internes à la cellule sont quant à eux, disposés à l'extérieur de la zone photosensible, à la périphérie de celle-ci.

De telles cellules photosensibles sont par conséquent conçues pour recevoir sur leur face d'entrée une lumière convergente, de telle sorte que l'intégralité de la lumière qui pénètre dans la cellule par sa face d'entrée parvienne à la zone photosensible, sans qu'une partie de cette lumière ne soit perdue parce qu'elle éclaire des composants électroniques intégrés à la cellule et non la zone photosensible.

Une telle cellule photosensible peut être utilisée avec une lumière rendue convergente au moyen de dispositifs optiques usuels si la face d'entrée et la zone photosensible sont séparées d'une distance de l'ordre de 6 µm environ. Si cette distance est trop grande, les dispositifs usuels au moyen desquels une lumière incidente sur la face d'entrée de cellules photosensibles est rendue convergente ne sont plus adaptés. Or une telle distance, par exemple supérieure à 6 µm, peut apparaître lorsque le substrat porte par ailleurs des composants électroniques réalisés sous la forme de plusieurs niveaux de métallisation. En effet, dans les technologies CMOS de fabrication de circuits électroniques actuellement utilisées, cinq ou six niveaux de métallisation sont répartis dans autant de couches de matériau isolant disposées sur la surface du substrat. Ces couches de matériaux isolant représentent alors une épaisseur totale supérieure à 10 µm au-dessus de la surface du substrat, voire de l'ordre de 12 µm environ. Lorsque la zone photosensible est portée par la surface du substrat et lorsque la face d'entrée de la lumière est située au niveau de la surface supérieure du matériau isolant, le foyer de convergence de faisceaux lumineux convergents tels qu'usuellement utilisés et envoyés au travers de la face d'entrée de la cellule est situé au-dessus de la zone photosensible, à environ 4 à 6 µm de cette dernière. Une divergence du faisceau lumineux intervient donc entre ce foyer et la zone photosensible, aboutissant à une section du faisceau lumineux au niveau de la surface du substrat plus grande que la superficie de la zone photosensible. Une partie de la lumière entrant dans la cellule au niveau de la face d'entrée est par conséquent perdue, provoquant une réduction de la sensibilité de la cellule.

La présente invention propose une configuration de cellule photosensible portée par un substrat qui ne présente pas cet inconvénient, bien que le substrat porte par ailleurs des circuits électroniques répartis dans un matériau isolant qui s'étend jusqu'à une hauteur déterminée au-dessus de la surface du substrat.

Un premier aspect de la présente invention concerne un dispositif électronique qui comprend un substrat ayant une surface, au moins un matériau isolant disposé au-dessus d'au moins une première portion de la surface du substrat jusqu'à une première hauteur par rapport à la surface du substrat, et des circuits électriques répartis au sein du matériau isolant. Le dispositif comprend aussi au moins une zone photosensible disposée dans au moins une seconde portion de la surface du substrat disjointe de ladite première portion, et au moins un premier matériau transparent recouvrant ladite zone photosensible jusqu'à une seconde hauteur par rapport à la surface du substrat. Selon l'invention, ladite seconde hauteur est inférieure à ladite première hauteur. Ainsi, la face d'entrée de la cellule photosensible portée par la surface supérieure dudit premier matériau transparent est abaissée par rapport à la surface supérieure du matériau isolant au sein duquel sont répartis les circuits électriques. La distance comprise entre la face d'entrée et la zone photosensible est alors compatible avec les faisceaux de lumière convergents habituellement utilisés.

Eventuellement, la cellule photosensible comprend au moins un dispositif optique convergent agencé au-dessus du premier matériau transparent, d'un côté du premier matériau transparent opposé à la zone photosensible. Ce dispositif convergent peut comprendre une microlentille convergente, réalisée de façon connue de l'homme du métier sur la surface supérieure du premier matériau transparent. Une telle microlentille présente usuellement une distance focale dans ce premier matériau transparent d'environ 4 à 6 µm, qui correspond alors approximativement à la distance entre la face d'entrée de la cellule photosensible et la zone photosensible. Une lentille convergente supplémentaire disposée au-dessus de la face d'entrée de la cellule, à une distance déterminée de celle-ci, peut être combinée avec la microlentille. Dans le cas d'une matrice de cellules photosensibles portée par le substrat, une microlentille est agencée au dessus de chaque cellule, alors que la lentille convergente supplémentaire est commune à l'ensemble des cellules de la matrice.

En outre, la cellule photosensible peut comprendre un second matériau transparent disposé au-dessus du premier matériau transparent recouvrant la zone photosensible, d'un côté du premier matériau transparent opposé à la zone photosensible, jusqu'à une troisième hauteur par rapport à la surface du substrat. Cette troisième hauteur est alors supérieure à la seconde hauteur. De plus, l'indice de réfraction optique du second matériau transparent est supérieur à l'indice de réfraction optique du premier matériau transparent. Il peut être éventuellement aussi supérieur à l'indice du matériau isolant entre lesdites troisième et première hauteurs. Un tel second matériau transparent ainsi disposé permet d'augmenter la distance entre la face d'entrée de la lumière dans la cellule et la zone photosensible tout en conservant un foyer de convergence des faisceaux de lumière habituellement utilisés situé au niveau de la surface du substrat. Il permet en outre de disposer des composants électroniques de contrôle de la cellule photosensible à l'intérieur du premier matériau transparent, sans provoquer une perte d'une partie de la lumière pénétrant dans la cellule par la face d'entrée. En effet, de tels composants électroniques peuvent être disposés dans une partie du premier matériau transparent qui n'est pas traversée par un faisceau de lumière convergent pénétrant dans la cellule, grâce à une convergence de ce faisceau intervenant au niveau du second matériau transparent.

En présence du second matériau transparent, l'éventuel dispositif optique convergent (i.e. la microlentille convergente dans l'exemple considéré) est alors agencé au-dessus du second matériau transparent, d'un côté du second matériau transparent opposé au premier matériau transparent et à la zone photosensible.

Lorsque lesdites première et troisième hauteurs sont choisies égales entre elles, la face d'entrée de la lumière dans la cellule photosensible et la surface supérieure du matériau isolant au sein duquel sont répartis les circuits électriques sont alors situées dans un même plan parallèle à la surface du substrat.

Lorsque les circuits électriques sont réalisés en utilisant à plusieurs reprises un procédé de planarisation, du type CMP (« Chemical Physical Polishing ») ou Damascène connu de l'homme du métier, le matériau isolant peut comprendre au moins quatre couches superposées selon une direction perpendiculaire à la surface du substrat. Il peut comprendre notamment cinq ou six couches, aboutissant à une hauteur totale de matériau isolant incorporant des circuits électriques de l'ordre de 10 à 12 µm. Dans ce cas, ladite seconde hauteur est préférentiellement inférieure ou égale à une hauteur à partir de la surface du substrat correspondant aux trois premières couches du matériau isolant comptées à partir de la surface du substrat.

Le matériau isolant au sein duquel sont répartis les circuits électriques et le premier matériau transparent peuvent avoir des indices de réfraction optique respectifs qui sont identiques. Ces deux matériaux peuvent aussi être identiques. Dans ce cas, les couches inférieures de matériau isolant disposées sur le substrat peuvent alors être continûment prolongées entre les première et seconde portions de surface du substrat.

Dans des modes de réalisation particuliers de l'invention, les différentes couches de matériau isolant dans lesquelles sont réparties les circuits électriques peuvent être constituées de matériaux isolants respectifs distincts. De même, le premier matériau transparent et, éventuellement, le second matériau transparent peuvent être remplacés respectivement par des empilements de plusieurs couches de matériaux constitutifs transparents variés. Dans ce cas, les indices de réfraction optique à considérer dans l'invention pour le matériau isolant, le premier matériau transparent et, éventuellement le second matériau transparent, sont les moyennes des indices de réfraction optique de leurs matériaux constitutifs respectifs, pondérées par les épaisseurs des couches correspondantes.

Un second aspect de l'invention concerne un procédé de fabrication d'un dispositif électronique particulier du type précédent. Ce procédé comprend les étapes suivantes :
a) on élabore une zone photosensible dans au moins une seconde portion d'une surface d'un substrat ;
b) on élabore au moins une couche de matériau isolant et transparent sur la surface du substrat au niveau de ladite seconde portion de la surface du substrat et d'au moins une première portion de la surface du substrat disjointe de ladite seconde portion, la couche de matériau isolant et transparent s'étendant jusqu'à une première hauteur par rapport à la surface du substrat, et on répartit les circuits électriques dans ladite couche de matériau isolant au niveau de ladite première portion de surface du substrat ;
c) on retire une partie du matériau isolant et transparent située au droit de la zone photosensible de façon à former une cavité, ladite cavité ayant un fond sensiblement parallèle à la surface du substrat et situé à une seconde hauteur par rapport à la surface du substrat qui est inférieure à ladite première hauteur. Ce retrait peut être effectué, par exemple, à l'aide d'un plasma de gravure.

Dans un mode de réalisation avantageux du procédé de l'invention, on élabore, lors de l'étape b), au moins quatre couches du matériau isolant et transparent superposées selon une direction perpendiculaire à la surface, et s'étendant ensemble jusqu'à ladite première hauteur. Lors de l'étape c), le retrait d'une partie du matériau isolant et transparent au droit de la zone photosensible peut alors être effectué de telle façon que la seconde hauteur par rapport à la surface du substrat est inférieure ou égale à une hauteur à partir de la surface du substrat correspondant aux trois premières couches du matériau isolant comptées à partir de la surface du substrat.

Dans une étape supplémentaire intervenant après l'étape c), un dispositif optique convergent peut être agencé au dessus de la zone photosensible, d'un côté dudit matériau isolant et transparent opposé au substrat. Le dispositif optique convergent peut comprendre une microlentille disposée sur la surface supérieure du matériau isolant et transparent dans la cavité.

En variante, le procédé de l'invention comprend en outre une étape d) suivant laquelle on remplit au moins partiellement la cavité d'un autre matériau transparent, l'indice de réfraction optique dudit autre matériau transparent étant supérieur à l'indice de réfraction optique du matériau isolant et transparent.

Le dispositif optique convergent peut être alors agencé lors d'une étape e) effectuée après l'étape d), d'un côté dudit autre matériau transparent opposé au substrat et à la zone photosensible. Ce dispositif peut encore être une microlentille, disposée sur la surface supérieure dudit autre matériau transparent.

D'autres particularités et avantages de la présente invention apparaîtront dans la description ci-après de deux exemples de réalisation non limitatifs, en référence aux dessins annexés, dans lesquels :
- la figure 1 est une vue en coupe d'un substrat portant des circuits électriques et une cellule photosensible selon un premier mode de réalisation de l'invention ;
- la figure 2 est une vue en coupe d'un substrat portant des circuits électriques et une cellule photosensible selon un second mode de réalisation de l'invention.

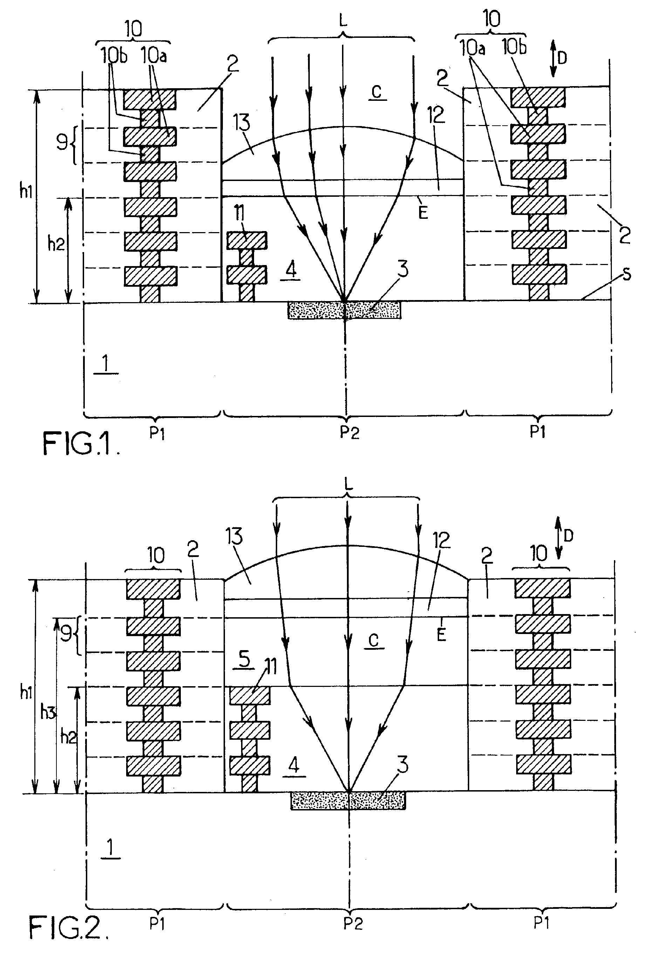

Selon la figure 1, un substrat 1, par exemple de silicium monocristallin, comporte une zone photosensible 3 au niveau d'une surface plane S de ce substrat. Cette zone photosensible 3 est disposée dans une portion P2 de la surface S, et est par exemple constituée par une zone de jonction d'une photodiode élaborée par implantation d'espèces dopantes dans une partie de la portion P2 de la surface S. De façon connue de l'homme du métier, une photodiode, polarisée électriquement en sens inverse par rapport au sens de conduction d'un courant électrique lié aux espèces dopantes implantées, permet le passage d'un courant électrique fonction de l'intensité lumineuse reçue au niveau de sa surface de jonction. Eventuellement, la portion P2 de la surface S peut comporter plusieurs, voire un grand nombre de zones photosensibles 3 de façon à former une matrice de zones photosensibles juxtaposées.

L'axe de la cellule photosensible est alors perpendiculaire à la surface S du substrat 1, et coupe la surface S en un point situé au centre de la zone photosensible 3. Cet axe de la cellule est parallèle à la direction D représentée sur la figure 1.

Au-dessus d'une portion P1 de la surface S adjacente à la portion P2 de la surface S et disjointe de cette dernière, des circuits électriques 10 sont élaborés selon une technologie usuelle, dite planarisante. Ces circuits électriques 10 comprennent notamment des liaisons métalliques, par exemple de cuivre, agencées sous forme de lignes 10a parallèles à la surface du substrat 1. Ils comprennent aussi des connexions 10b disposées entre certaines des lignes 10a. Ces connexions 10b sont agencées selon la direction D et sont connues sous le nom de «vias». Les lignes 10a et les connexions 10b sont par exemple disposées selon des niveaux superposés selon la direction D, dits niveaux de métallisation. Chaque niveau de métallisation est créé au sein d'une couche respective 9 de matériau d'isolation électrique 2, par exemple de silice SiC₂ ou à base de silice, parallèle à la surface S. Cette couche 9 de matériau d'isolation électrique 2 assure notamment une fonction de support mécanique des circuits électriques 10. Les couches 9 de matériau d'isolation électrique 2, avec leurs circuits métalliques 10 respectifs, sont successivement élaborées sur la surface S, en partant de cette surface, au niveau de la portion de surface P1. Chaque couche 9 présente par exemple une épaisseur d'environ 2 µm. Un empilement de couches ayant une hauteur h1 d'environ 12 µm correspond par exemple à six couches superposées, incorporant six niveaux de métallisation.

Au niveau de la portion de surface P2 qui comporte la zone photosensible 3, un premier matériau transparent 4 recouvre le substrat 1. Ce premier matériau 4 est préférentiellement aussi en silice.

Dans un mode de mise en oeuvre avantageux de l'invention, le premier matériau transparent 4 est élaboré en même temps que les premières couches 9 de matériau d'isolation électrique 2 présent au niveau de la portion de surface P1. Pour cela, chacune des six couches 9 de silice est élaborée simultanément sur la réunion des deux portions P1 et P2 de la surface S, mais sont dépourvues de circuits électriques au niveau de la zone photosensible 3. Eventuellement, des circuits électriques 11 de dimensions réduites peuvent être incorporés dans les couches 9 au niveau de la portion de surface P2, en dehors de la zone photosensible 3. De tels circuits 11, appartenant à la cellule photosensible, en permettent notamment des opérations de lecture et d'initialisation.

Un masque est alors déposé par photolithographie par-dessus des couches 9, qui les recouvre au niveau de la portion P1 de la surface S. L'ensemble est alors exposé à un plasma de gravure directionnelle selon un procédé connu de l'homme du métier («dry etching»). Le matériau correspondant aux trois couches 9 supérieures de silice est alors retiré par le plasma, formant la cavité C. La gravure est arrêtée lorsqu'une hauteur h2 de silice résiduelle au niveau de la zone P2 est atteinte, qui correspond par exemple à la hauteur totale des trois couches 9 de silice inférieures. La hauteur h2 est par exemple égale à environ 6 µm.

Selon une première configuration des cellules photosensibles de l'invention, la surface supérieure du matériau transparent 4 constitue la face d'entrée E de la lumière dans la cellule photosensible.

L'élaboration de la cellule photosensible, ou des cellules dans le cas d'une matrice, est alors complétée, de façon optionnelle, par le dépôt d'un filtre coloré 12 au niveau de la face d'entrée E de chaque cellule photosensible. Lorsque la portion P2 de surface comporte une matrice de cellules photosensibles, des filtres colorés 12 de trois couleurs complémentaires peuvent être distribués sur les faces d'entrée E de cellules photosensibles adjacentes selon un motif connu, pour construire une information de couleur en chaque point de la matrice.

L'élaboration de la ou des cellules est en outre poursuivie par la réalisation d'une microlentille 13 par-dessus le filtre coloré 12 de chaque cellule photosensible. Cette microlentille 13 est obtenue, par exemple, de façon connue de l'homme du métier, par le dépôt sur la surface supérieure du filtre coloré 12 d'une petite quantité de matériau transparent solide, capable de se liquéfier lors d'un chauffage modéré. Un tel matériau peut être organique, tel qu'une résine choisie pour sa valeur de tension superficielle à l'état liquide. Il prend alors, lorsqu'il est chauffé, une forme correspondant approximativement à une partie de sphère et constitue une lentille plan-convexe au-dessus de la face d'entrée E de la cellule photosensible.

Lorsqu'un faisceau parallèle de lumière L est envoyé dans la cellule photosensible, au travers de la face d'entrée E, selon une direction approximativement parallèle à la direction D, ce faisceau est rendu convergent par la microlentille 13. Selon l'invention, grâce à la disposition du matériau transparent 4 avec une épaisseur h2 appropriée, inférieure à la hauteur h1, le faisceau de lumière L converge en un point situé approximativement au niveau de la surface S. Ainsi, tous les rayons entrant dans la cellule photosensible par sa face d'entrée E parviennent à la zone photosensible 3, bien que celle-ci présente des dimensions transversales, c'est-à-dire dans le plan de la surface S, inférieures aux dimensions de la face d'entrée E dans un plan parallèle à la surface S. De ce fait, les circuits électriques 11 disposés à l'intérieur de la cellule photosensible ne réduisent pas la lumière qui parvient à la zone photosensible 3.

La figure 2 montre une seconde configuration de cellules photosensibles selon l'invention. De telles cellules photosensibles sont obtenues par un procédé dont une première partie est identique à celle du procédé décrit plus haut. La cavité C formée lors du retrait du matériau transparent 4 est comblée par un matériau transparent de remplissage 5 jusqu'à une hauteur h3 au-dessus de la surface S, par exemple de 10 µm environ. De façon préférée, l'indice de réfraction optique du matériau de remplissage 5 est élevé, en particulier supérieur à celui de la silice constituant le matériau isolant et transparent 2 qui fait aussi office de premier matériau transparent 4 dans le présent exemple. Le matériau de remplissage 5 peut être, par exemple, de l'oxyde de tantale Ta₂O₅, de l'oxyde de titane TiO₂, de l'oxyde de zirconium ZrO₂, de l'oxyde d'yttrium Y₂O₃, de l'oxyde d'étain SnO₂, ou un alliage de certains de ces oxydes. Un tel alliage peut encore incorporer de la silice SiO₂, dans une proportion déterminée pour présenter un indice de réfraction optique adapté. Le matériau de remplissage 5 peut encore être du type d'un nitrure transparent, tel que le nitrure de silicium Si₃N₄, le nitrure d'aluminium AIN, le nitrure de zirconium Zr₃N₄, le nitrure de tantale TaN, etc, ou du type oxynitrure d'un ou de plusieurs métaux associés. Des matériaux organiques d'un type proche de ceux utilisés pour les microlentilles peuvent également être utilisés. La surface supérieure du matériau de remplissage 5 constitue alors la face d'entrée E de la cellule photosensible.

L'élaboration de la cellule est alors poursuivie de la façon déjà décrite, en procédant au dépôt éventuel du filtre coloré 12 et à la réalisation de la microlentille 13 sur la surface supérieure du matériau de remplissage 5.

Dans cette seconde configuration de la cellule photosensible, du fait de la microlentille 13, une première convergence d'un faisceau de lumière parallèle L envoyé sur la face d'entrée E de la cellule photosensible intervient dans le matériau de remplissage 5. Cette première convergence permet de disposer dans la cellule, au sein du matériau isolant et transparent 2, des circuits électriques 11 plus volumineux que ceux compatibles avec la première configuration de cellule photosensible illustrée par la figure 1. La focalisation du faisceau est obtenue à l'issue d'une seconde convergence, intervenant au niveau du matériau isolant et transparent 2. Grâce à l'indice de réfraction optique élevé du matériau de remplissage 5, la première convergence est limitée, si bien que le foyer de convergence du faisceau de lumière parallèle L est encore situé au niveau de la zone photosensible 3.

## Revendications

1. Dispositif électronique comprenant un substrat (1) ayant une surface (S), au moins un matériau isolant (2) disposé au-dessus d'au moins une première portion (P1) de la surface (S) du substrat jusqu'à une première hauteur (h1) par rapport à la surface du substrat, des circuits électriques (10) répartis au sein du matériau isolant, et comprenant au moins une zone photosensible (3) disposée dans au moins une seconde portion (P2) de la surface du substrat disjointe de ladite première portion (P1), au moins un premier matériau transparent (4) recouvrant ladite zone photosensible jusqu'à une seconde hauteur (h2) par rapport à la surface (S) du substrat, dans lequel ladite seconde hauteur (h2) est inférieure à ladite première hauteur (h1).

2. Dispositif selon la revendication 1, comprenant en outre au moins un dispositif optique convergent (12) agencé au-dessus du premier matériau transparent (4), d'un côté du premier matériau transparent opposé à la zone photosensible (3).

3. Dispositif selon la revendication 1, comprenant en outre un second matériau transparent (5) qui est disposé au dessus du premier matériau transparent (4) recouvrant la zone photosensible (3), d'un côté du premier matériau transparent opposé à la zone photosensible, le premier (4) et le second (5) matériaux transparents ayant des indices de réfraction optique respectifs, dans lequel l'indice de réfraction optique du second matériau transparent (5) est supérieur à l'indice de réfraction optique du premier matériau transparent (4).

4. Dispositif selon la revendication 3, dans lequel le matériau isolant (2) possède un indice de réfraction inférieur à l'indice de réfraction du second matériau transparent (5).

5. Dispositif selon l'une quelconque des revendications 3 à 4, comprenant en outre au moins un dispositif optique convergent (12) agencé au-dessus du second matériau transparent (5), d'un côté du second matériau transparent opposé au premier matériau transparent (4) et à la zone photosensible (3).

6. Dispositif selon la revendication 2 ou la revendication 5, dans lequel le dispositif optique convergent (12) comprend une microlentille convergente.

7. Dispositif selon l'une quelconque des revendications précédentes, dans lequel le matériau isolant (2) et le premier matériau transparent (4) ont des indices de réfraction optique respectifs qui sont identiques.

8. Dispositif selon l'une quelconque des revendications précédentes, dans lequel le matériau isolant (2) comprend au moins quatre couches (9) superposées selon une direction (D) perpendiculaire à la surface du substrat.

9. Dispositif selon la revendication 8, dans lequel ladite seconde hauteur (h2) est inférieure ou égale à une hauteur à partir de la surface (S) du substrat correspondant aux trois premières couches du matériau isolant (2) comptées à partir de la surface (S) du substrat.

10. Procédé de fabrication d'un dispositif électronique suivant lequel :
a) on élabore une zone photosensible (3) dans au moins une seconde portion (P2) d'une surface (S) d'un substrat (1) ;
b) on élabore au moins une couche de matériau isolant et transparent (2) sur la surface (S) du substrat (1) au niveau de ladite seconde portion (P2) de la surface du substrat et d'au moins une première portion (P1) de la surface du substrat disjointe de ladite seconde portion (P2), la couche de matériau isolant et transparent s'étendant jusqu'à une première hauteur (h1) par rapport à la surface (S) du substrat, et on répartit des circuits électriques (10) dans ladite couche de matériau isolant au niveau de ladite première portion (P1 ) de surface du substrat ;
c) on retire une partie du matériau isolant et transparent (2) située au droit de la zone photosensible (3) de façon à former une cavité (C), ladite cavité ayant un fond sensiblement parallèle à la surface (S) du substrat et situé à une seconde hauteur (h2) par rapport à la surface (S) du substrat qui est inférieure à ladite première hauteur (h1).

11. Procédé selon la revendication 10, suivant lequel le retrait de la partie du matériau isolant et transparent (2) située au droit de la zone photosensible (3) est effectué à l'aide d'un plasma.

12. Procédé selon la revendication 10 ou la revendication 11, suivant lequel, lors de l'étape b), on élabore au moins quatre couches (9) du matériau isolant et transparent (2) superposées selon une direction (D) perpendiculaire à la surface (S).

13. Procédé selon l'une quelconque des revendications 10 à 12, suivant lequel, lors de l'étape c), le retrait d'une partie du matériau isolant et transparent (2) au droit de la zone photosensible est effectué de telle façon que la seconde hauteur (h2) par rapport à la surface (S) du substrat est inférieure ou égale à une hauteur à partir de la surface (S) du substrat correspondant aux trois premières couches du matériau isolant (2) dans lequel sont répartis des circuits électriques (10), ces couches étant comptées à partir de la surface (S) du substrat.

14. Procédé selon l'une quelconque des revendications 10 à 13, comprenant en outre, après l'étape c), une étape suivant laquelle on agence un dispositif optique convergent (12) au dessus de la zone photosensible (3), d'un côté dudit matériau isolant et transparent (2) opposé au substrat (1).

15. Procédé selon l'une quelconque des revendications 10 à 13, comprenant en outre une étape d) suivant laquelle on remplit au moins partiellement la cavité (C) d'un autre matériau transparent (5), l'indice de réfraction optique dudit autre matériau transparent (5) étant supérieur à l'indice de réfraction optique du matériau isolant et transparent (2).

16. Procédé selon la revendication 15, comprenant en outre, après l'étape d), une étape e) suivant laquelle on agence un dispositif optique convergent (12) d'un côté dudit autre matériau transparent (5) opposé au substrat (1) et à la zone photosensible (3).
